# EUROPEAN PATENT SPECIFICATION

(11) **EP 1 583 244 B1**
(45) Date of publication and mention of the grant of the patent: **20.06.2007**
(21) Application number: 04425241.9
(22) Date of filing: 01.04.2004
(51) Int. Cl.: H03M 1/46

(54) **Low consumption and low noise analog-digital converter of the SAR type and method of employing it**
Verfahren und Gerät zur Analog/Digitalwandlung von SAR Typ mit niedrigem Verbrauch und Rausch
Procédé et dispositif de conversion analogique-numérique de SAR à faible consommation et bruit

(43) Date of publication of application: 05.10.2005
(73) Proprietor: STMicroelectronics S.r.l., 20041 Agrate Brianza (Milano) (IT)
(72) Inventor: Confalonieri, Pierangelo, 20040 Caponago (Milano) (IT); Zamprogno, Marco, 20031 Cesano Maderno (Milano) (IT); Girardi, Francesca, 20131 Milano (IT)
(74) Representative: Siniscalco, Fabio

(56) References cited:
- EP-A- 0 504 805
- US-B1- 6 329 938
- US-B2- 6 556 164
- PATENT ABSTRACTS OF JAPAN vol. 005, no. 099 (E-063), 26 June 1981 (1981-06-26) & JP 56 044225 A (MATSUSHITA ELECTRIC IND CO LTD), 23 April 1981 (1981-04-23)

## Description

The present invention relates to an analog-digital converter of the SAR type as defined in the preamble of Claim 1 hereinbelow, and as is known for example from EP 0504805, and a method of employing it.

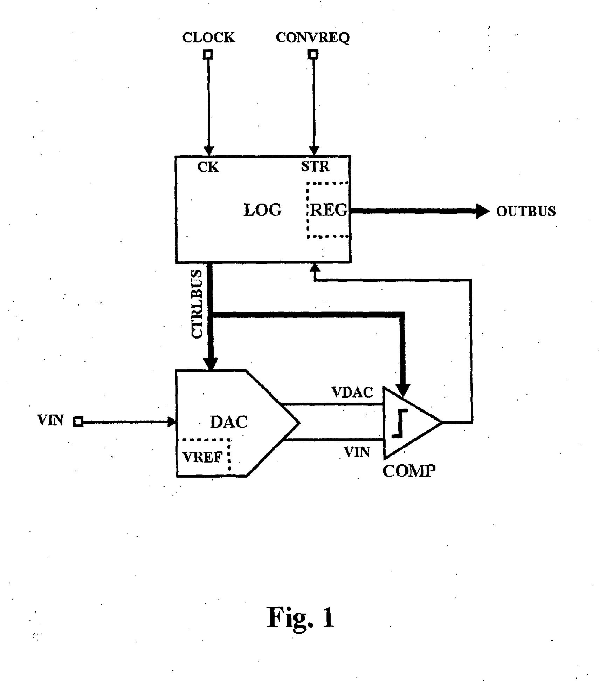

An analog-digital converter of the SAR (Successive Approximation Register) type is illustrated in a schematic manner by Figure 1. It comprises elements for the quantization of an analog input parameter to be converted, in the form of a digital-analog converter DAC (which includes a reference voltage source VREF) and a comparator COMP, and a logic unit LOG (which includes a register REG) with timing and control functions connected to the converter DAC and the comparator COMP by means of a control bus CTRLBUS. A signal of timing or clock pulses (CLOCK) is applied to a terminal CK of the logic unit. An input voltage to be converted VIN is applied to the converter DAC and a conversion request signal CONVREQ is applied to a starting terminal STR of the logic unit LOG. A sequence of clock-pulse timed signals activates the converter DAC and the comparator COMP and makes possible the loading of the sample VIN to be converted. The register REG is set to a digital value corresponding to the centre of the scale of the conversion range (10000000 in the case of an 8-bit register). The converter DAC therefore furnishes an output voltage of VDAC=VREF/2. The comparator COMP compares this voltage with the voltage VIN and provides the result of the comparison to the logic unit. When VIN>VDAC, the comparator output is a logic "1" and the most significant bit of the register remains at "1". But when VIN<VDAC, the output of the comparator is a logic "0" and the most significant bit of the register is switched to a logic "0". The next bit of the register is then set to "1", followed by another comparison with the same criterion, and this is continued until the least significant bit has been examined. At this point the conversion is finished and the register contains the digital code, in this example consisting of 8 bits, corresponding to the input voltage VIN. This code is available at the output OUTBUS of the logic unit LOG and the register REG, which is the output of the converter.

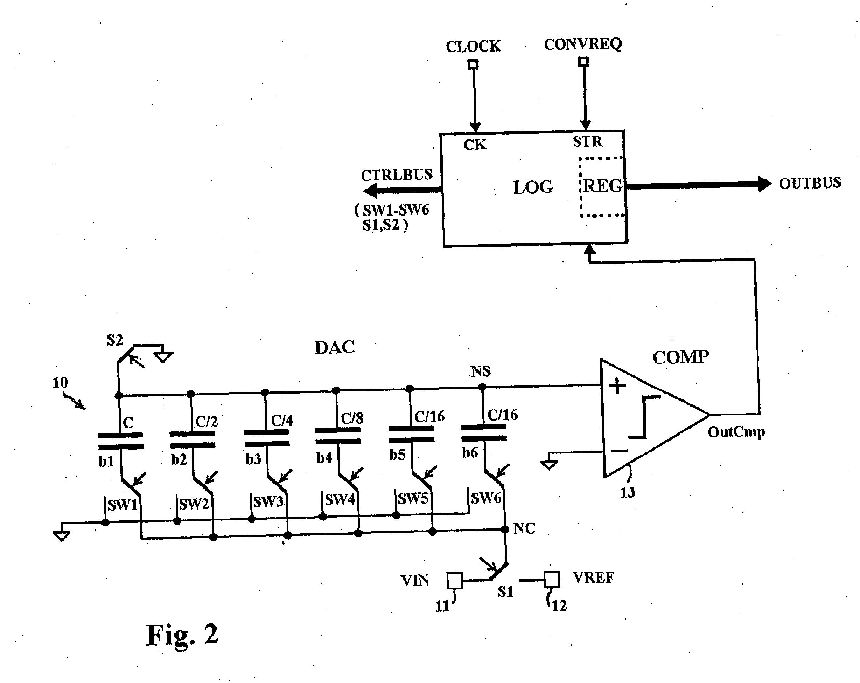

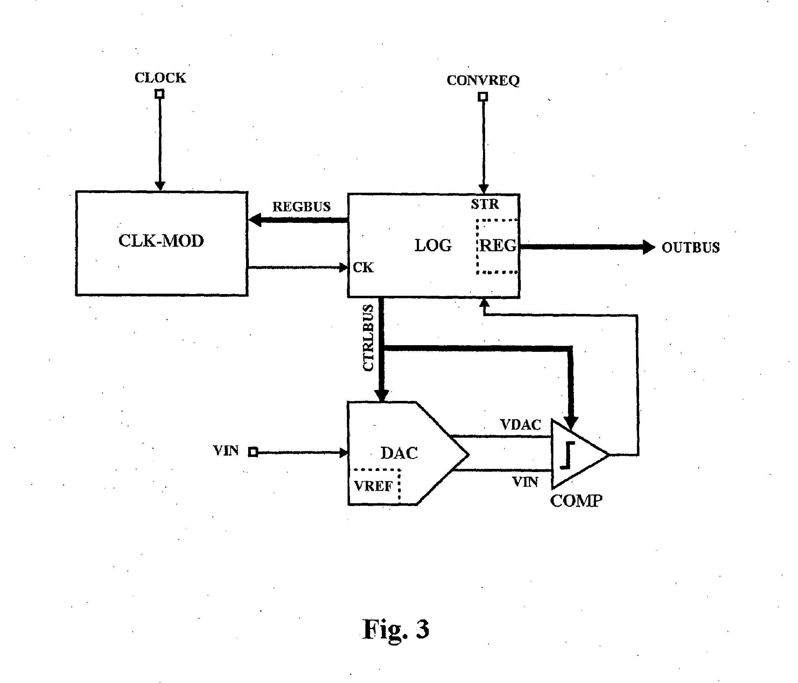

A typical analog-digital converter of the SAR type uses a digital-analog converter DAC of the switched capacitor type, as shown in Figure 2. For simplicity of representation, the figure shows a converter having a resolution of only 5 bits, but it is well known that converters with a much larger number of bits are used in actual practice, 12 being a case in point. The converter of Figure 3 comprises an array 10 of six capacitors b1-b6 with each of which there is associated a two-way switch SW1-SW6. The capacitors b5 to b1 are weighted in binary code, i.e. they have capacitances that increase in accordance with a factor 2ⁱ, where i may vary between 0 and 4. The sixth capacitor, b6, has a capacitance equal to that of the capacitor b5 and serves to assure that the sum of the capacitances of the array will be exactly double the capacitance of the capacitor b1.

One electrode of each of the capacitors is connected to a common terminal NS. The two-way switches serve to connect the other electrode of each of the capacitors selectively to a first terminal, indicated by NC, or a second terminal, indicated by the ground symbol. The terminal NS may be connected to ground or may be left free by means of a one way switch S2. By means of a two-way switch S1, the terminal NC may be selectively connected to an input terminal 11 to which there is applied the input signal VIN of the analog-digital converter or to a reference terminal 12 on which there is present the reference voltage VREF (provided by the voltage source included in the block DAC in the scheme of Figure 1) .

The terminal NS is connected to the non-inverting input terminal of an operational amplifier 13 that performs the function of the comparator COMP of Figure 1. The inverting input terminal of the operational amplifier 13 is connected to ground. The output OutCmp of the comparator is connected to the logic unit LOG. The bus CTRLBUS issuing from the logic unit LOG carries control signals for the two-way switches SW1-SW6, the one-way switch S2 and the two-way switch S1 to operate them in accordance with a predetermined timing programme and as a function of the comparator output. It is to be understood that the two-way switches and the one-way switch are in practice constituted by controllable electronic connection devices, for example MOS transistors or combinations of MOS transistors. The logic unit LOG records the position of the switches SW1-SW5 in the register REG in order to furnish on the output OUTBUS a digital code corresponding to the analog input signal VIN.

Briefly described, the converter functions as follows:
- in a first phase, the sampling phase, the switches are controlled by the logic unit LOG in such a manner as to be in the positions shown in Figure 2, i.e. with the terminal NC connected by means of the switch S1 to the input terminal 11, to which there is applied the signal VIN to be converted, with the terminal NS connected by means of the switch S2 to ground and with all the lower electrodes of the capacitors connected by means of the switches SW1-SW6 associated with them to the terminal NC, so that all the capacitors are charged to the voltage VIN (referred to ground);
- in the subsequent phase, the storage phase, the logic unit LOG causes the switch S2 to open and then causes the switches SW1-SW6 to switch and thus to connect the lower electrodes of all the capacitors to ground, with the result that the common terminal NS of the array 10 will assume the voltage -VIN (referred to ground);
- at this point the logic unit LOG commences the operations typical of SAR technique to identify by means of successive attempts the values of the bits that make up the binary code that represents the sample of the analog input voltage; each "attempt" is carried out in one period of the clock signal; more particularly,
- during the high-level part of the clock signal, with a view to finding the most significant bit (first "attempt"), the lower electrode of the capacitor b1 of greater capacitance (C) is connected to the terminal 12, which is at the reference voltage VREF, by means of the switching of the switches SW1 and S1: this causes the voltage of the terminal NS to rise from -VIN to - VIN+VREF/2; the reference voltage VREF is chosen in such a way as to have a value equal to the maximum voltage VIN that can be converted;
- during the low-level part of the clock signal the comparator COMP carries out a comparison: when the voltage -VIN+REF/2 is negative, the comparator COMP will have a low output signal and the logic unit LOG will maintain the switch SW1 in the position in which the lower electrode of the capacitor b1 is connected to the reference terminal 12 (VREF) and will transmit this position information to the register REG as corresponding to bit 1;
- on the other hand, when the voltage -VIN+VREF/2 is positive, the comparator COMP will have a high output signal and the logic unit LOG will bring the switch SW1 back into the position in which the lower electrode of the capacitor b1 is connected to ground and will transmit this position information to the register REG as corresponding to a bit 0;
- the same operation is carried out for the capacitor b2 in a subsequent period of the clock signal to find the second bit (second "attempt") and then repeated for all the remaining capacitors, excluding only the last, b6, which remains connected to ground for the entire duration of the SAR operations;
- at the end the register REG will contain five bits that represent the final position of the switches SW1-SW5 and the binary code corresponding to the value of the sample input voltage VIN.

In the realization of a switched-capacitor converter of the type described above the source of the reference voltage VREF is in practice constituted by a buffer connected to a biasing circuit. This circuit is made in such a way as to generate a stable and precise reference voltage, substantially insensitive to temperature variations, supply voltage fluctuations of the integrated circuit and the variability of the manufacturing parameters. The buffer is typically constituted by an operational amplifier having a pass band sufficiently wide to satisfy the switching speed requirements of the converter and a capacity of supplying current such as to satisfy the power requirements of the converter.

Considering the functioning of a typical switched-capacitor converter in accordance with Figure 2, one should note that the phase of charging the capacitors of the converter DAC in the subsequent operations (or "attempts") to determine the values of the bits to be sent to the output register is decisive for the purposes of dimensioning the reference voltage buffer. In particular, the buffer must be capable of charging the capacitors during one clock pulse, i.e. during the high part of the clock signal, which in the case of a typical clock signal with a duty cycle of 50% is half the period. The time available for charging the capacitors may be even shorter in actual practice if one bears in mind the fact that when one sets out to fabricate an integrated circuit containing a clock generator designed for a nominal duty cycle of 50%, one may obtain a real duty cycle comprised between 40% and 60% due to the effect of the variability of the manufacturing parameters. The designer must therefore take account of this uncertainty regarding the value of the duty cycle and dimension the buffer for the worst possible conditions.

A typical field of application of analog-digital converters of the type described above is that of cellular telephones. A strongly felt need when designing these telephones, as also many other types of battery-operated portable equipment, is to reduce the consumption of electric energy to a minimum. Analog-digital converters are among the devices that make a significant contribution to the consumption of the equipment. In particular, the contribution that the buffer makes to the overall consumption of the integrated circuit of which it forms part is always considerable and, in many cases, constitutes the greater part of the consumption of the converter.

The principal object of the present invention is to propose an analog-digital converter of the SAR type and a method of employing such a converter that will make possible a low consumption of electric energy.

Another object is to propose an analog-digital converter of the SAR type and a method of employing such a converter that will make it possible to eliminate or at least reduce the noise generated by the converter the while it functions.

These and other objects are attained by realizing the converter defined in general terms in Claim 1 and putting into practice the method set out in general terms in Claim 5.

The invention will be more clearly understood from the following detailed description of some of its embodiments, which are given by way of example and are not to be considered limitative in any way, the description making reference to the attached drawings, of which:
- Figure 1 schematically illustrates a known analog-digital converter of the SAR type,
- Figure 2 shows a known analog-digital converter of the SAR type with switched capacitors,
- Figures 3 and 4 show the schematic layouts of two analog-digital converters of the SAR type in accordance with a first and a second embodiment of the invention, and
- Figures 5 to 8 each show some waveforms that illustrate different modes of functioning of the converter of Figure 4.

The converter of Figure 3 comprises the same functional blocks (DAC, COMP, LOG) of the converter of Figure 1, but differs from the latter by virtue of the fact that the timing pulses that arrive at the terminal CK of the logic unit LOG come from a unit, indicated by CLK-MOD, that is capable of modifying the clock pulses arriving from the system clock (CLOCK) in response to control signals provided by the logic unit LOG via a bus indicated by REGBUS. More particularly, these control signals modify the period and/or the duty cycle of the clock pulses in a discrete manner, in steps equal to half a clock period, and on the basis of criteria defined in the logic unit.

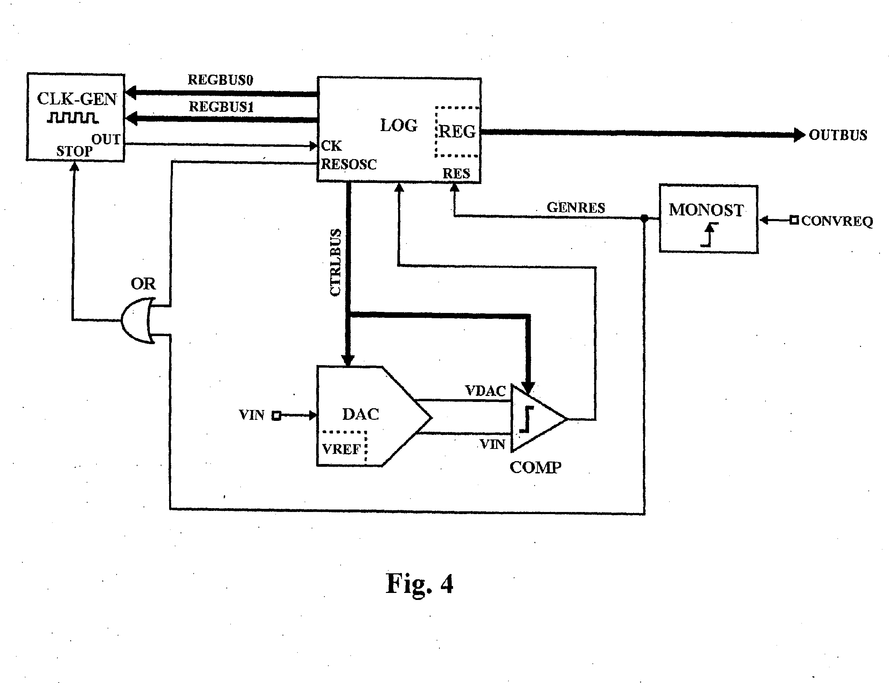

The converter of Figure 4 once again comprises some functional blocks equal to those of the converter of Figure 1, namely the blocks LOG, DAC and COMP, and also a clock pulse generator CLK-GEN, a generator of single pulses, in this example a monostable analog circuit MONOST, and an OR logic gate. It should only be noted that the logic unit LOG is provided with an additional output RESOSC for a signal that will stop the generator CLK-GEN and two outputs, REGBUS0 and REGBUS1, for regulating the operating parameters of the generator. It should also be noted that the logic unit LOG has a starting terminal, here indicated by RES, that also performs a resetting function, as will be explained further on. A converter equal to the one of Figure 4 is described in a patent application filed by the applicants on the same day as the present application and entitled "Analog-digital converter".

The generator CLK-GEN has an output terminal OUT connected to the clock terminal CK of the logic unit LOG, an input activation terminal STOP connected to the output of the OR gate and two inputs connected to the logic unit by means of the two buses REGBUS0 and REGBUS1. The monostable circuit has an input terminal to which there is applied the conversion request signal CONVREQ and an output terminal GENRES connected to the starting and resetting input terminal RES of the logic unit and to an input terminal of the OR gate. The latter has a second input terminal connected to the output terminal RESOSC of the logic unit.

The generator CLK-GEN and the quantization elements DAC and COMP are incorporated in one and the same integrated circuit. Preferably, the other circuit blocks of Figure 4 will also form part of the same integrated circuit.

The generator CLK-GEN is a pulse generator that becomes active when a binary signal applied to its input STOP finds itself in a predetermined state of its two logic states and on its output terminal OUT produces an oscillation that can immediately be used because it is not affected by transitory phenomena. Furthermore, when the signal at its input terminal STOP switches to the other of the two logic states, it stops in a known condition, i.e. all its nodes always have the same predetermined binary values; therefore, when it is restarted (STOP=0), it does so with an oscillation of the correct value right from the first half-period. A generator of this type is described in European Patent Application No. 04425100.7 filed by applicants on 18 February 2004 under the title "Clock-pulse generator circuit".

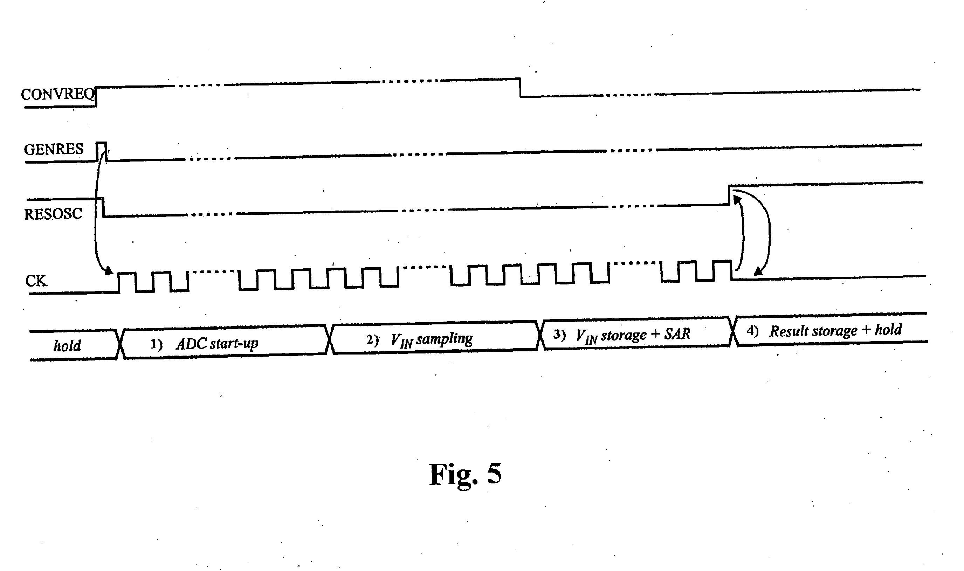

Let us now consider the functioning of the converter of Figure 4 with reference to the waveforms shown in Figure 5.

Following a conversion request, the monostable circuit generates a pulse GENRES of a predetermined duration. In this example the pulse GENRES is produced when the signal CONVREQ applied as input to the monostable circuit switches from 0 to 1 and has a duration sufficient to set the logic unit LOG in its initial condition. In practice the signal GENRES brings a counter contained in the logic unit back to 0, sets the output RESOSC to 0 (for example, by means of a flip-flop which is controlled by the signal GENRES and maintains the set state also after the end of the signal GENRES) and prevents the activation of the oscillator for the whole of its duration. Indeed, it should be noted that the generator will not oscillate until STOP=1, i.e. both with RESOSC=1 and GENRES=1, while it will oscillate when STOP=0, i.e. only when the two inputs of the OR gate (RESOSC and GENRES) are both at 0. Be it noted also that in this way the start-up of the oscillator is delayed by a time equal to the duration of the pulse GENRES. When the pulse of the monostable circuit terminates (GENRES=0), the generator produces a clock signal CK that has a frequency and a duty cycle determined by the digital signals present on the buses REGBUS0 and REGBUS1, until such time as RESOSC returns to 1 and brings the generator to a halt (STOP=1) . During the activity of the generator the clock signal increases the contents of the counter of the logic unit LOG, giving rise to the successive emission of the signals needed to cause the quantization elements (DAC, COMP) to perform the operations, timed by the timing pulses, for the conversion of the analog input sample VIN into a digital code. Starting from an initial condition of deactivation (hold) of all the circuits, during which the consumption of the device is only such as is due to the leakage currents, the conversion is performed in accordance with the following phases:
1) ACDstart-up: activation of the analog parts of the converter (DAC, reference voltage source, comparator COMP, possible biasing circuits);
2) VINsampling: the voltage signal VIN to be converted is loaded in the capacitors of the converter DAC (capacitor array 10 of Figure 2);
3) VINstorage+SAR: the voltage VIN is memorized and the SAR procedure for the determination of the digital code corresponding to VIN is commenced;
4) Resultstorage+hold: the result is conveyed onto the output bus OUTBUS, the pulse generator is stopped and the analog parts are deactivated following an appropriate command of the logic unit.

At the beginning of Phase 4) the last trailing edge of the clock signal assures that the counter of the logic unit LOG will cause the signal RESOSC to switch to 1 (and also assure the transfer of the digital code resulting from the conversion to the bus OUTBUS and the deactivation of the circuits). The generator will therefore have STOP=1 at the activation input, so that the output OUT remains at 0 and the clock signal stops after the pulse that brought about the condition RESOSC=1: from this it follows that the logic unit LOG will cease all activity on account of the lack of a clock signal. This state is maintained until a new leading edge of the conversion request signal CONVREQ. The number of clock pulses for each phase depends on the circuit characteristics and parameters.

In the example described in relation to Figures 4 and 5 we considered a clock signal with a duty cycle of 50%. Nevertheless, this duty-cycle value, as also the frequency of the clock signal, may be changed arbitrarily, even while the generator is functioning, by appropriately changing the digital codes that the logic unit sends to the clock pulse generator on the buses bars REGBUS0 and REGBUS1.

Similarly, in the example illustrated by Figure 3 the duty cycle and the period may be modified (discretely, in steps equal to half a period) by means of the digital signals sent by the logic unit LOG to the clock signal modification unit CLK-MOD via the bus REGBUS.

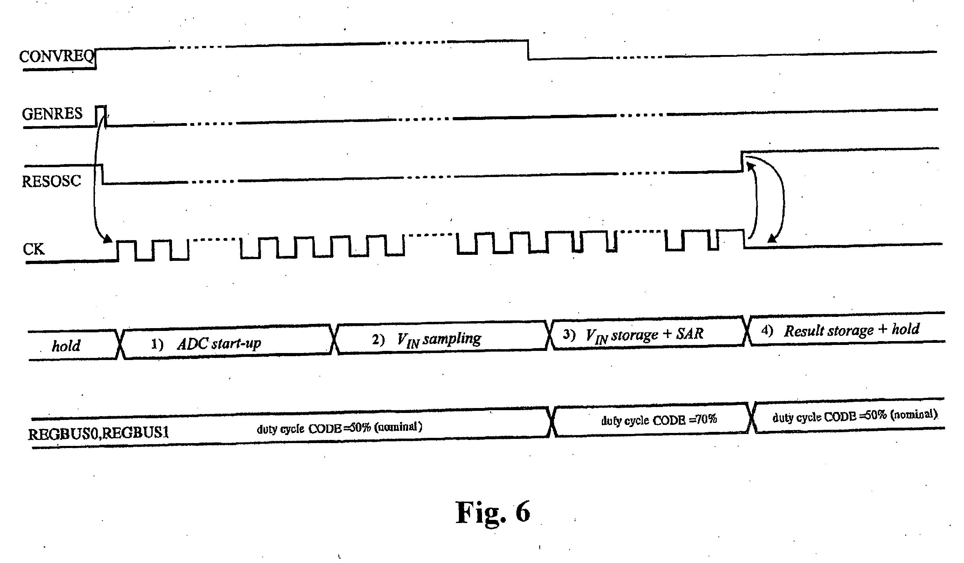

The possibility of modifying the timing pulses, together with the fact that the time needed for the comparison operation performed by the comparator COMP is much shorter than half a period of the clock signal, implies considerable advantages in terms of energy saving. In fact, the logic unit LOG may be programmed for regulating the duty cycle of the timing pulses in such a way that more time will be accorded to the charging operations than to the comparison operations. For example, as shown in Figure 6, while the clock signal in Phases 1) and 2) has a duty cycle of 50%, in Phase 3) it has a duty cycle of 70% even though it maintains the same period. This behaviour is obtained by supplying to the generator CLK-GEN, via the bus bars REGBUS0 and REGBUS 1, digital codes that determine a duty cycle of 50% in Phases 1), 2) and 4), and digital codes that determine a duty cycle of 70% in Phase 4) and, more precisely, digital codes that determine a clock signal that will maintain its high value for a longer time for the charging phases and its low value for a shorter period of time for the comparison phases. Thanks to this possibility of modifying the duty cycle, the buffer of the reference voltage may be designed with maximum performances inferior to those of a known converter, with the advantage of a smaller energy consumption in operation.

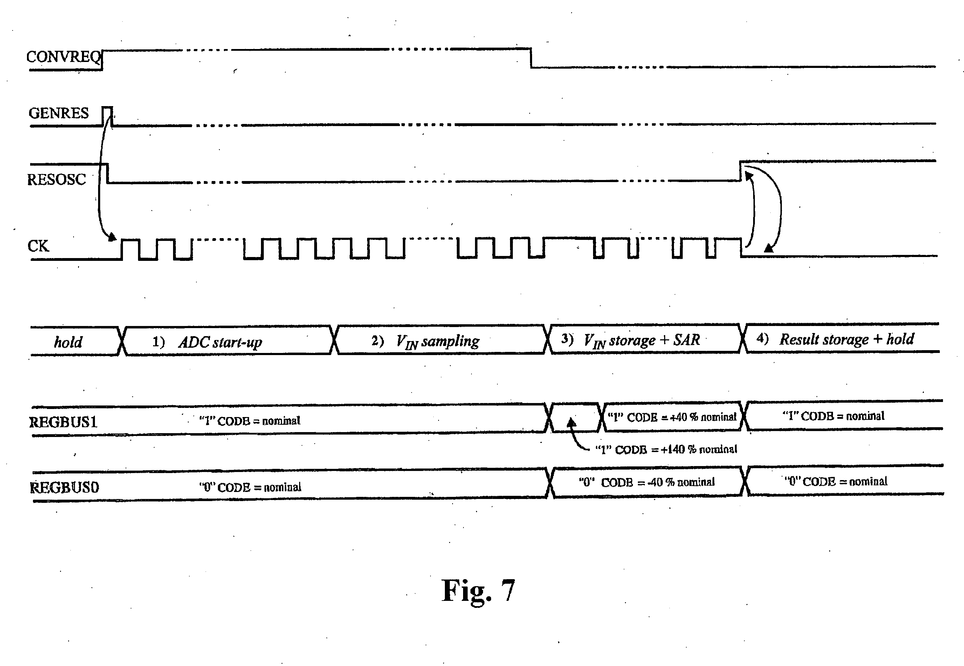

A further reduction of the consumption may be obtained by a further regulation of the duration of the clock signal during Phase 3). It should be noted that the consumption connected with the charging of the capacitors to the reference voltage VREF is directly proportional to the capacitances that have to be charged and inversely proportional to the time available for charging. Now, the maximum charging capacitance is associated with the first "attempt", i.e. with the charging of the capacitors for determining the most significant bit. The capacitances to be charged will thereafter reduce, halving on the occasion of each subsequent "attempt". If the clock signal is correspondingly modified to take account of this, one obtains a further significant reduction of the consumption of the buffer of the voltage VREF. Figure 7 shows the case in which the digital code applied to REGBUS1 is such as to prolong the duration of the high value of the clock signal up to 140% for the first "attempt", while maintaining the duty cycle at 70% for the remaining "attempts". If this were desirable, it would also be possible to diversify the durations for the subsequent "attempts", even though the advantages in terms of energy saving reduce very rapidly as the order number of the "attempts" increases.

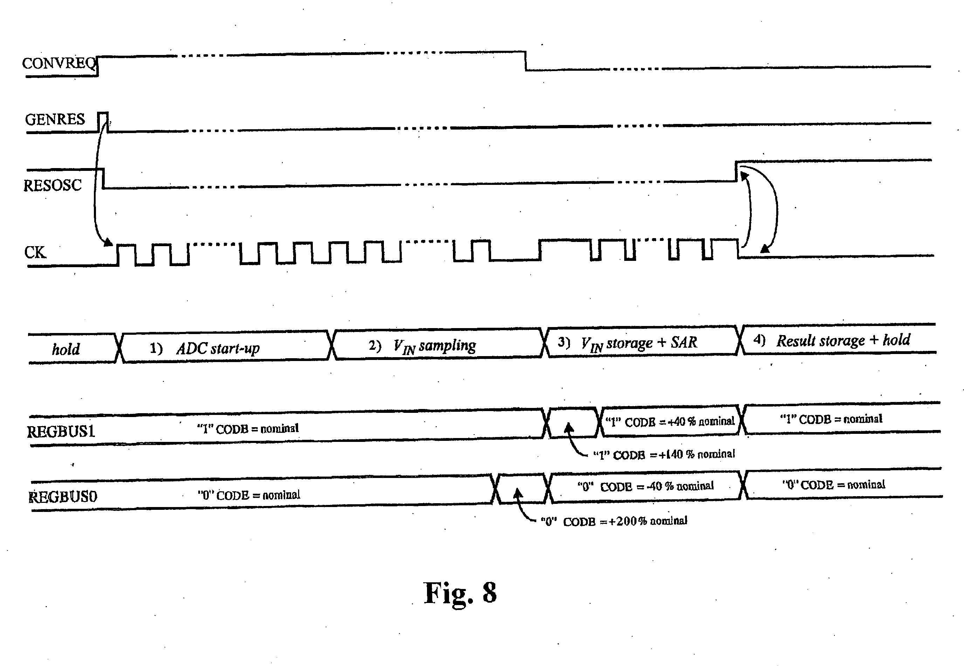

The converter and the method in accordance with the invention make it possible to eliminate or, at least, drastically reduce the noise and the offset that can be induced by parasite phenomena when relatively large currents are switched in the generator. The parasite phenomena are due to the inductances, resistances and capacitances associated with the connections between the integrated circuit and the terminals that connect it to the external circuits and can cause a damped oscillation on the supply voltages. A very critical phase of the functioning of the converter is the one in which the converter voltage VIN is memorized. If the edge of the clock pulse preceding the one used for the memorization generates an oscillation that has not yet been damped when the memorization edge arrives, the voltage VIN with respect to ground becomes altered, so that the memorized voltage is different from the one it is desired to convert. This problem is the more serious the higher the clock requency is. To avoid this happening, the half-period of the clock signal that precedes the memorization edge - as shown in Figure 8 - is lengthened, tripled for example. To this end the code applied to the bus REGBUS0, which determines the duration of the time during which the clock signal maintains its low value, is appropriately modified before the memorization edge, so that the memorization edge will arrive when the oscillation has been practically completely damped.

As clearly brought out by what has been said above, the objects of the invention are fully attained, because with the described converter and method the electric energy necessary for performing the conversion can be determined without waste on the basis of the effective needs of each phase of the conversion and the noise normally associated with the switching of large currents in the clock generator can be practically eliminated.

## Claims

1. An analog-digital converter of the SAR type comprising:
- switched-capacitor quantization means (DAC, COMP) having an input for receiving and storing an analog quantity to be converted (VIN);
- a register (REG) having an output (OUTBUS) for providing a digital quantity corresponding to the analog quantity;
- a timing pulse generator (CLK-MOD; CLK-GEN) and
- logic means (LOG) connected to the quantization means (DAC, COMP), the register (REG) and the timing pulse generator (CLK-MOD; CLK-GEN), capable of responding to a conversion request signal (CONVREQ) by activating the switched-capacitor quantization means in such a way that the switched-capacitor quantization means will carry out predetermined operations timed by timing pulses and load in to the register (REG) the digital quantity to be furnished to the output (OUTBUS),
said logic means (LOG) comprising means for producing regulation signals and said timing pulse generator (CLK-MOD; CLK-GEN) comprising regulation means capable of modifying the duration of the timing pulses in response to regulation signals (REGBUS; REGBUSO, REGBUS1) produced by the logic means,
**characterized in that**
said regulation means of the timing pulse generator regulate such as to modify the duration of the timing pulses by modifying the duty cycle of the timing pulses.

2. An analog-digital converter according to claim 1, wherein:
- said switched-capacitor quantization means (DAC, COMP) are suitable to perform an identification step, in a course of successive attempts, by means of operations of charging the capacitors and performing comparisons in accordance with SAR techniques, of bit values of the digital quantity corresponding to the analog quantity to be converted, and
- said regulation means of the timing pulse generator are such to modify said duty cycle in said identification step in such a way as to prolong the operations of charging the capacitors and to shorten the respective comparison operations.

3. An analog-digital converter according to claim 1 or 2, wherein:
- said switched-capacitor quantization means (DAC, COMP) are suitable to perform, in response to a given timing pulse, a step of storing said analog quantity,
- said regulation means of the timing pulse generator are such to modify said duty cycle in such a way as to increase a duration of a half-period of a timing pulse immediately preceding said given timing pulse.

4. An analog digital converter cording to claim 1, wherein said regulation means of the timing pulse generator are such to modify the duration of the timing pulses also by modifying the frequency of the timing pulses.

5. A method for converting an analog quantity (VIN) into a digital code (OUTBUS) by means of an analog-digital converter of the SAR type including switched-capacitors quantization means (DAC, COMP) and logic means (LOG), said converter having predetermined operations timed by timing pulses, comprising the steps of:
- loading of the analog quantity to be converted (VIN) in the switched capacitors quantization means (DAC, COMP),
- storing in response to a given timing pulse the loaded analog quantity and
- identifying in the course of successive attempts, by means of operations of charging the capacitors and performing comparisons in accordance with SAR techniques, bit values of the digital quantity corresponding to the analog quantity to be converted,
modifying the duration of the timing pulses during at least one of the steps indicated above in response to regulation signals emitted by the logic means (LOG),
**characterized in that**
said step of modifying the duration of the timing pulses is such as to modify the duty cycle of said timing pulses.

6. A method in accordance with Claim 5, wherein in said modifying step the duration of the timing pulses in the step of identification by successive attempts is modified in such a way as to prolong the operations of charging the capacitors and to shorten the respective comparison operations.

7. A method in accordance with Claim 6, wherein the frequency of the timing pulses is maintained unaltered.

8. A method in accordance with Claim 5, wherein in said modifying step the duration of the timing pulse in the operation of charging the capacitors for a first attempt of said course of successive attempts is greater than the duration of the timing pulses for the subsequent attempts.

9. A method in accordance with any one of Claims 5 to 8, wherein in said modifying step, in response to a given timing pulse, a duration of a half-period of a timing pulse immediately preceding said given timing pulse is increased.

## Patentansprüche

1. Ein Analog-Digital-Wandler vom SAR-Typ, aufweisend:
eine Quantisierungseinrichtung vom Typ eines geschalteten Kondensators (DAC, COMP) mit einem Eingang für das Empfangen und Speichern einer umzuwandelnden analogen Größe (VIN);
ein Register (REG) mit einem Ausgang (OUTBUS) für das Bereitstellen einer digitalen Größe, die der analogen Größe entspricht;
einen Zeitsteuerungsimpulsgenerator (CLK-MOD; CLK-GEN) und
eine Logikeinrichtung (LOG), die mit der Quantisierungseinrichtung (DAC, COMP), dem Register (REG) und dem Zeitsteuerungsimpulsgenerator (CLK-MOD; CLK-GEN) verbunden und in der Lage ist, auf ein Umwandlungsanforderungssignal (CONVREQ) durch das Aktivieren der Quantisierungseinrichtung vom Typ eines geschalteten Kondensators derart zu antworten, dass die Quantisierungseinrichtung vom Typ eines geschalteten Kondensators durch Zeitsteuerungsimpulse zeitgesteuerte vorherbestimmte Operationen ausführt und die an den Ausgang (OUTBUS) zu liefernde digitale Größe in das Register (REG) lädt,
wobei die Logikeinrichtung (LOG) eine Einrichtung für das Erzeugen von Regulierungssignalen aufweist und der Zeitsteuerungsimpulsgenerator (CLK-MOD; CLK-GEN) eine Regulierungseinrichtung aufweist, die dazu in der Lage ist, die Dauer der Zeitsteuerungsimpulse als Antwort auf von der Logikeinrichtung erzeugte Regulierungssignale (REGBUS; REGBUSO, REGBUS1) zu modifizieren,
**dadurch gekennzeichnet, dass**
die Regulierungseinrichtung des Zeitsteuerungsimpulsgenerators auf eine solche Weise reguliert, dass die Dauer der Zeitsteuerungsimpulse durch das Modifizieren des Tastverhältnisses der Zeitsteuerungsimpulse modifiziert wird.

2. Analog-Digital-Wandler nach Anspruch 1, wobei:
die Quantisierungseinrichtung vom Typ eines geschalteten Kondensators (DAC, COMP) dafür geeignet ist, einen Schritt der Identifizierung von Bit-Werten der digitalen Größe, die der umzuwandelnden analogen Größe entsprechen, in einem Verlauf von aufeinanderfolgenden Versuchen mittels Operationen des Ladens der Kondensatoren und des Durchführens von Vergleichen gemäß SAR-Techniken auszuführen, und
die Regulierungseinrichtung des Zeitsteuerungsimpulsgenerators so beschaffen ist, dass sie das Tastverhältnis in dem Identifizierungsschritt auf eine solche Weise modifiziert, dass die Operationen des Ladens der Kondensatoren verlängert werden und die entsprechenden Vergleichsoperationen verkürzt werden.

3. Analog-Digital-Wandler nach Anspruch 1 oder 2, wobei:
die Quantisierungseinrichtung vom Typ eines geschalteten Kondensators (DAC, COMP) dafür geeignet ist, als Antwort auf einen gegebenen Zeitsteuerungsimpuls einen Schritt des Speicherns der analogen Größe auszuführen,
die Regulierungseinrichtung des Zeitsteuerungsimpulsgenerators so beschaffen ist, dass sie das Tastverhältnis auf eine solche Weise modifiziert, dass eine Dauer einer halben Periode eines Zeitsteuerungsimpulses, der dem gegebenen Zeitsteuerungsimpuls direkt vorausgeht, verlängert wird.

4. Analog-Digital-Wandler nach Anspruch 1, wobei die Regulierungseinrichtung des Zeitsteuerungsimpulsgenerators so beschaffen ist, dass sie die Dauer des Zeitsteuerungsimpulses auch durch das Modifizieren der Frequenz des Zeitsteuerungsimpulses modifiziert.

5. Verfahren für das Umwandeln einer analogen Größe (VIN) in einen digitalen Code (OUTBUS) mittels eines Analog-Digital-Wandlers vom SAR-Typ, der eine Quantisierungseinrichtung vom Typ eines geschalteten Kondensators (DAC, COMP) und eine Logikeinrichtung (LOG) aufweist, wobei der Wandler von Zeitsteuerungsimpulsen zeitgesteuerte vorherbestimmte Operationen hat, aufweisend folgende Schritte:
Laden der umzuwandelnden analogen Größe (VIN) in die Quantisierungseinrichtung vom Typ eines geschalteten Kondensators (DAC, COMP),
Speichern der geladenen analogen Größe als Antwort auf einen gegebenen Zeitsteuerungsimpuls,
Identifizieren von Bit-Werten der digitalen Größe, die der umzuwandelnden analogen Größe entsprechen, im Verlauf von aufeinander folgenden Versuchen mittels Operationen des Ladens der Kondensatoren und des Durchführens von Vergleichen gemäß SAR-Techniken,
Modifizieren der Dauer der Zeitsteuerungsimpulse während mindestens eines der oben aufgezeigten Schritte als Antwort auf von der Logikeinrichtung (LOG) emittierte Regulierungssignale,
**dadurch gekennzeichnet, dass**
der Schritt des Modifizierens der Dauer der Zeitsteuerungsimpulse so beschaffen ist, dass das Tastverhältnis der Zeitsteuerungsimpulse modifiziert wird.

6. Verfahren nach Anspruch 5, wobei in dem Modifizierungsschritt die Dauer der Zeitsteuerungsimpulse in dem Schritt des Identifizierens durch aufeinander folgende Versuche derart modifiziert wird, dass die Operationen des Ladens der Kondensatoren verlängert werden und die entsprechenden Vergleichsoperationen verkürzt werden.

7. Verfahren nach Anspruch 6, wobei die Frequenz der Zeitsteuerungsimpulse unverändert aufrechterhalten bleibt.

8. Verfahren nach Anspruch 5, wobei in dem Modifizierungsschritt die Dauer des Zeitsteuerungsimpulses bei der Operation des Ladens der Kondensatoren für einen ersten Versuch des Verlaufs von aufeinander folgenden Versuchen länger ist als die Dauer der Zeitsteuerungsimpulse für die anschlie-ßenden Versuche.

9. Verfahren nach einem der Ansprüche 5 bis 8, wobei in dem Modifizierungsschritt als Antwort auf einen gegeben Zeitsteuerungsimpuls eine Dauer einer halben Periode eines Zeitsteuerungsimpulses, der dem gegebenen Zeitsteuerungsimpuls direkt vorausgeht, verlängert wird.

## Revendications

1. Convertisseur analogique-numérique du type SAR comprenant :
- un moyen de quantification à capacité commutée (DAC, COMP) ayant une entrée pour recevoir et stocker une quantité analogique à convertir (VIN) ;
- un registre (REG) ayant une sortie (OUTBUS) pour fournir une quantité numérique correspondant à la quantité analogique ;
- un générateur d'impulsion de temporisation (CLK-MOD ; CLK-GEN) et
- un moyen logique (LOG) raccordé au moyen de quantification (DAC, COMP), le registre (REG) et le générateur d'impulsion de temporisation (CLK-MOD ; CLK-GEN), capables de répondre à un signal de demande de conversion (CONVREQ) en activant le moyen de quantification à capacité commutée de manière à ce que le moyen de quantification à capacité commutée réalise des opérations prédéterminées cadencées par des impulsions de temporisation et charge dans le registre (REG) la quantité numérique à fournir à la sortie (OUTBUS),
ledit moyen logique (LOG) comprenant un moyen pour produire des signaux de régulation et ledit générateur d'impulsion de temporisation (CLK-MOD ; CLK-GEN) comprenant un moyen de régulation capable de modifier la durée des impulsions de temporisation en réponse aux signaux de régulation (REGBUS ; REGBUS0, REGBUS1) produits par le moyen logique,
**caractérisé en ce que**
ledit moyen de régulation du générateur d'impulsion de temporisation régule afin de modifier la durée des impulsions de temporisation en modifiant le cycle de charge des impulsions de temporisation.

2. Convertisseur analogique-numérique selon la revendication 1, dans lequel :
- lesdits moyens de quantification à capacité commutée (DAC, COMP) sont appropriés pour réaliser une étape d'identification, au cours des essais successifs, au moyen d'opérations de charge des condensateurs et réalisation de comparaisons selon des techniques SAR, de valeurs binaires de la quantité numérique correspondant à la quantité analogique à convertir, et
- lesdits moyens de régulation du générateur d'impulsion de temporisation sont pour modifier ledit cycle de charge dans ladite étape d'identification de manière à prolonger les opérations de charge des condensateurs et pour raccourcir les opérations de comparaison respectives.

3. Convertisseur analogique-numérique selon la revendication 1 ou 2, dans lequel :
- lesdits moyens de quantification à capacité commutée (DAC, COMP) sont appropriés pour réaliser, en réponse à une impulsion de temporisation donnée, une étape de stockage de ladite quantité analogique,
- lesdits moyens de régulation du générateur d'impulsion de temporisation sont pour modifier ledit cycle de charge de manière à augmenter une durée d'une demi-période d'une impulsion de temporisation précédant immédiatement ladite impulsion de temporisation donnée.

4. Convertisseur analogique-numérique selon la revendication 1, dans lequel lesdits moyens de régulation du générateur d'impulsion de temporisation sont pour modifier la durée des impulsions de temporisation aussi en modifiant la fréquence des impulsions de temporisation.

5. Procédé pour convertir une quantité analogique (VIN) en un code numérique (OUTBUS) au moyen d'un convertisseur analogique-numérique du type SAR comprenant un moyen de quantification à capacité commutée (DAC, COMP) et un moyen logique (LOG), ledit convertisseur ayant des opérations prédéterminées cadencées par des impulsions de temporisation, comprenant les étapes de
- charge de la quantité analogique à convertir (VIN) dans le moyen de quantification à capacité commutée (DAC, COMP),
- stockage en réponse à une impulsion de temporisation donnée de la quantité analogique chargée et,
- identification au cours des essais successifs, au moyen des opérations de charge de condensateurs et réalisation de comparaisons selon des techniques SAR, des valeurs binaires de la quantité numérique correspondant à la quantité analogique à convertir,
modification de la durée des impulsions de temporisation pendant au moins une des étapes indiquées ci-dessus en réponse aux signaux de régulation émis par le moyen logique (LOG),
**caractérisé en ce que**
ladite étape de modification de la durée des impulsions de temporisation est pour modifier le cycle de charge desdites impulsions de temporisation.

6. Procédé selon la revendication 5, dans lequel dans ladite étape de modification, la durée des impulsions de temporisation dans l'étape d'identification par des essais successifs est modifiée de manière à prolonger les opérations de charge des condensateurs et pour raccourcir les opérations de comparaison respectives.

7. Procédé selon la revendication 6, dans lequel la fréquence des impulsions de temporisation est maintenue inchangée.

8. Procédé selon la revendication 5, dans lequel dans ladite étape de modification, la durée de l'impulsion de temporisation dans l'opération de charge de condensateurs pour un premier essai de ladite course d'essais successifs est plus grande que la durée des impulsions de temporisation pour les essais qui suivent.

9. Procédé selon l'une quelconque des revendications 5 à 8, dans lequel dans ladite étape de modification, en réponse à une impulsion de temporisation donnée, une durée d'une demi-période d'une impulsion de temporisation précédant immédiatement ladite impulsion de temporisation donnée est augmentée.
